Europäisches Patentamt

European Patent Office

Office européen des brevets

(11) Veröffentlichungsnummer: **0 496 372 A2**

## EUROPÄISCHE PATENTANMELDUNG

(21) Anmeldenummer: **92100999.9**

(51) Int. Cl.⁵: **C25D 5/50**, C23C 18/16

(22) Anmeldetag: **22.01.92**

(30) Priorität: **24.01.91 DE 4101974**
**06.03.91 DE 4107142**

(43) Veröffentlichungstag der Anmeldung:
**29.07.92 Patentblatt 92/31**

(84) Benannte Vertragsstaaten:
**AT CH DE FR GB IT LI NL SE**

(71) Anmelder: **Hoechst CeramTec**
**Aktiengesellschaft**
**Wilhelmstrasse 14**
**W-8672 Selb(DE)**

(72) Erfinder: **Thimm, Alfred, Dr.**

Beethovenstrasse 17
W-8592 Wunsiedel(DE)
Erfinder: **Bindig, Reiner**
August-Mayer-Strasse 17
W-8598 Waldershof(DE)
Erfinder: **Brandenburger, Jürgen, Dr.**
Plössberger Weg 23
W-8672 Selb(DE)

(74) Vertreter: **Spiess, Bernhard**
**Hoechst AG Zentrale Patentabteilung**
**Postfach 80 03 20**
**W-6230 Frankturt am Main 80(DE)**

(54) **Verfahren zur Herstellung von edelmetallbeschichteten Schichten eines unedlen Metalls.**

(57) Die Erfindung betrifft ein Bauteil mit einer edelmetallbeschichteten Metallschicht. Die Metallschicht enthält wenigstens 70 Gew.-% Eisen, Kobalt und/oder Nickel und das Edelmetall weist eine Schichtdicke von 0,1 bis 10 $\mu$m auf. An der Oberfläche der Metallschicht sind Metallkristallite vorhanden, wobei mindestens 30 % der Metallkristallite an der Oberfläche eine Korngröße von mindestens 2 $\mu$m oder mindestens 50 % eine Korngröße von mindestens 1 $\mu$m aufweisen. Die Erfindung betrifft auch ein Verfahren zur Herstellung einer Edelmetallbeschichtung auf einer Metallschicht, bei dem man die Metallschicht vor dem Beschichten mit dem Edelmetall in einer nicht oxidierenden Atmosphäre solange auf eine Temperatur im Bereich von 500°C bis 1300°C erhitzt, bis die Metallkristallite eine entsprechende Korngröße entwickelt haben, man die Metallschicht abkühlt und dann außenstromlos oder galvanisch mit der Beschichtung aus Edelmetall überzieht.

Fig. 1

**EP 0 496 372 A2**

Die Erfindung betrifft edelmetallbeschichtete Schichten eines Metalls der Eisengruppe, bei denen die bei höheren Temperaturen stattfindende Diffusion des Metalls der Eisengruppe in das Edelmetall hinein unterbunden oder stark verringert ist, sowie ein Verfahren zur Herstellung der Schichten.

Besonders in der elektronischen Industrie werden Bauelemente verwendet, die aus mehreren Schichten verschiedener metallischer und nichtmetallischer Substanzen bestehen. Dies gilt beispielsweise für keramische Gehäuse und elektronische Schaltkreise, die sich mit Hilfe der Dickschichttechnik herstellen lassen. Hierzu werden keramische Folien mit Pasten bedruckt, die Metalle, beispielsweise Wolfram oder Molybdän, enthalten. Nach dem Laminieren mehrerer so bedruckter Folien werden die Laminate in Einzelteile zerschnitten und gebrannt. Danach werden die sichtbaren Bereiche der entstandenen Metallisierung durch eine Schicht eines Metalls der Eisengruppe (diese Gruppe besteht aus Eisen, Nickel und Kobalt) verstärkt. Bevorzugt wird Nickel oder Kobalt oder deren Legierungen eingesetzt. Diese Schicht wird häufig "Sperrschicht" genannt. Anschließend wird das Metall der Eisengruppe mit einer dünnen Schicht eines Edelmetalls, meist Gold, überzogen.

In eine solche Packung wird dann ein Schaltkreis eingebracht und dort verankert, insbesondere eingeklebt, eingeglast oder einlegiert. Das Einglasen wird häufig mit Hilfe eines silber- und glashaltigen Epoxidharzes durchgeführt ("silver glass die attach"). Das organische Harz muß vor dem Herstellen der Kontakte zwischen Schaltkreis und Gehäuse, üblicherweise als 'Bonden' bezeichnet, restlos durch Verdampfen und Pyrolyse in oxidierender Atmosphäre entfernt werden. Die hierzu notwendige Wärmebehandlung erfolgt in der Regel bei Temperaturen zwischen 400 und 500°C und führt besonders bei den üblicherweise verwendeten dünnen Goldschichten von ca. 0,5 bis 3 $\mu$m zu deutlich sichtbaren Verfärbungen der Oberfläche, die störend sind und vermieden werden müssen.

Ursache für diese Verfärbungen ist die Diffusion der unedleren Metalle der Sperrschicht unter dem Gold in die Goldschicht hinein bis an die Goldoberfläche, wo dann bei höheren Temperaturen eine Oxidation zu den entsprechenden Oxiden erfolgt. Die Oxide von Nickel und Kobalt sind von dunkler Farbe und dadurch mit dem bloßen Auge als Verfärbung wahrzunehmen.

Weiterhin wird durch die Diffusion von Fremdatomen in das Gold dessen Härte heraufgesetzt.

Durch diese dünne Oxidschicht und durch die Erhöhung der Härte des Goldes treten beträchtliche Probleme bei der Verbindung von Schaltkreis mit Gehäuse auf. Diese Verbindung wird meist durch Drähte aus Gold oder Aluminium mittels Bonden hergestellt. Die Haftfestigkeit der entstehenden Bondstellen ist bei mit Oxiden belegten fremdatomhaltigen Edelmetallschichten deutlich herabgesetzt.

Aus der Literatur ist bekannt, daß eine Abscheidung weiterer Metallschichten zwischen Nickel und Gold die Diffusion des Nickels verzögern kann. Beispielsweise ist eine Schicht von Palladium gut wirksam. Die Abscheidung solcher Schichten ist jedoch, insbesondere bei größeren Schichtstärken, unökonomisch und verteuert das Endprodukt.

Mit dem erfindungsgemäßen Verfahren gelingt es, die Diffusion der Metalle der Sperrschicht durch das Edelmetall, insbesondere Gold, zu unterbinden oder zumindest auf ein nicht mehr erkennbares Ausmaß zu verzögern, ohne daß weitere Zwischenschichten abgeschieden werden müssen. Überraschend wurde gefunden, daß bei Eisen, Kobalt und Nickel die Diffusion durch das Innere der Kristallite um den Faktor 10 bis 100 langsamer verläuft als entlang der Korngrenzen und daß sie außerdem abhängig ist von der Kristallorientierung.

Galvanotechnisch und außen-stromlos abgeschiedene Nickelschichten bestehen aus kleinsten Kristallen mit einem Durchmesser von unter 0,1 $\mu$m. Je kleiner die Kristalle sind, umso stärker ist der Nachschub von Nickelatomen durch Korngrenzenduffusion. Das gleiche gilt für die Metalle Eisen und Kobalt.

Es wurde nun ein Verfahren zum Herstellen einer 0,1 bis 10 $\mu$m dicken Edelmetallbeschichtung auf einer dünnen Metallschicht gefunden, die zu mindestens 70 Gew.-% aus Eisen, Nickel und/oder Kobalt besteht und zunächst eine Kristallitgröße von maximal 0,5 $\mu$m aufweist, wobei man die Edelmetallbeschichtung in an sich bekannter Weise, z.B. galvanisch oder außenstromlos aufbringt. Das Verfahren ist gekennzeichnet durch die Merkmale von Patentanspruch 1.

Als Edelmetall für die Beschichtung lassen sich beispielsweise Silber oder Platinmetalle (wie Rh, Pd oder Pt) einsetzen, bevorzugt ist Gold. Möglich sind auch Legierungen von Edelmetallen. Durch die Behandlung bei 500°C bis 1300°C soll eine Rekristallisation der Schicht aus Nickel, Eisen oder Kobalt erreicht werden. Die Dauer der Behandlung hängt daher von der Temperatur ab. Bei 500°C verläuft die Rekristallisation langsam und braucht mindestens einen Tag. Bei 1300°C reicht eine Rekristallisationszeit von 1 Minute.

Das Verfahren ist insbesondere geeignet für eine Schicht aus Nickel, Eisen oder Kobalt, die auf einer Keramikschicht, z.B. auf $Al_2O_3$ oder AlN, oder auf einer metallisierten Keramikschicht aufgebracht ist.

Die Schicht aus Eisen, Nickel und Kobalt kann auch eine Legierung dieser Elemente untereinander oder mit anderen Metallen darstellen. Sie besteht vorzugsweise aus mindestens 80 % Fe, Ni und/oder Co. Beispielsweise kann die Schicht noch bis zu 20 % Chrom, Mangan, Molybdän und/oder Wolfram enthalten. Auch diese Legierungen lassen sich galvanisch und z.T. außenstromlos abscheiden. Metallschichten mit Phosphorgehalten, z.B. mit 1-20 Gew. % Phosphor lassen sich aus Hypophosphit enthaltenden Lösungen, Metallschichten mit Borgehalten, z.B. 0,1-5 Gew. % Bor, lassen sich aus Boranat oder ein Amino-Boran enthaltenden Lösungen abscheiden. Schichten aus Nickel/Phosphor weisen einen niedrigeren Schmelzpunkt als Reinnickel auf. Bei der thermischen Behandlung darf die Schicht nicht schmelzen.

Bei einer Temperatur von mindestens 700°C erfolgt die Rekristallisation von Nickel, Eisen und Kobalt besonders schnell. Bei Behandlungstemperaturen zwischen 500°C und 700°C kommt es nur zu einer langsamen Vergrößerung der Kristalle. In beiden Fällen steigt der durchschnittliche Durchmesser der Kristalle um einen Faktor von etwa 100 an, wobei sich Kristalle bilden, die in den drei Raumrichtungen etwa gleich groß sind. Die Schichtstärke bleibt durch die Wärmebehandlung unbeeinflußt. Die maximal mögliche Korngröße liegt in der Größenordnung der Schichtstärke. Erwünscht ist es, wenn die mittlere Korngröße 50 % bis 150 % der Schichtstärke ausmacht. Bei einer Vergrößerung der mittleren Korndurchmesser von 0,05 $\mu$m auf 5 $\mu$m verringert sich die Länge des für die Diffusion verantwortlichen Korngrenzennetzes auf der Oberfläche von Eisen, Kobalt, Nickel auf etwa 0,5 % bis 1 % des ursprünglichen Wertes.

Goldschichten, die im Rahmen des erfindungsgemäßen Verfahrens aufgetragen wurden, erleiden bei erhöhter Temperatur, wenn überhaupt, nur eine langsame Verfärbung der Goldoberfläche durch Diffusion und Oxidation des Metalls der Eisengruppe. Daher tritt bei der Verarbeitung des Schaltkreises noch keine erkennbare Verfärbung der Goldoberfläche ein und das Bonden wird nicht erschwert.

Bevorzugt sind Edelmetallschichten mit einer Schichtdicke im Bereich von 1 bis 5 $\mu$m, insbesondere von 1,5 bis 3 $\mu$m.

Das erfindungsgemäße Verfahren eignet sich ferner zur Beschichtung von massiven Blechen aus Eisen, Nickel und/oder Kobalt. Solche Bleche können z.B. eine Dicke von 0.1 bis 10 mm aufweisen. Die Kristalle können in Abhängigkeit von dem Verfahren zur Blech-Herstellung texturiert sein, d.h. eine Vorzugsausrichtung aufweisen oder nicht.

Die Erfindung betrifft ferner ein Bauteil mit einer edelmetallbeschichteten Metallschicht, wobei das Metall zu mindestens 70 Gew.-% aus Eisen, Kobalt und/oder Nickel besteht und die Edelmetallschicht eine Dicke von 0,1 bis 10 $\mu$m aufweist. In

der (nach Entfernung des Edelmetalls sichtbaren) Oberfläche des Metalls tragen mindestens 30 Flächen-% der Metalloberfläche Metallkristallite mit einer Korngröße von mindestens 2 $\mu$m oder mindestens 50 Flächen-% Kristallite mit einer Korngröße von mindestens 1 $\mu$m.

Die Metallschicht kann auf einem Keramikkörper angeordnet sein und weist dann eine Schichtdicke von 0.5-50 $\mu$m auf. Die Metallschicht kann aber auch alternativ ein massives Blech mit einer Dicke beispielsweise im Bereich von 0,5 bis 10 mm darstellen.

Die Vergrößerung der Kristalle während des Erhitzens auf 500-1300°C kann unter dem Mikroskop erkannt werden. Man kann jedoch auch eine Vermessung mit Hilfe von rasterelektronenmikroskopischen Untersuchungen (REM-Aufnahmen) durchführen. Beim Einbau der Probe in das Rasterelektronenmikroskop sollte auf einen Neigungswinkel von 0° geachtet werden.

Bewährt hat sich folgendes Vorgehen: Es werden etwa 4500-fache Vergrößerungen mit Formaten von mindestens 20x25 cm hergestellt. Die Körner, die größer als 1 $\mu$m bzw. 2 $\mu$m sind, werden gekennzeichnet. Als Korngrößenparameter wird der Äquivalentkreisdurchmesser gewählt, bei dem die Durchmesser von Kreisen verwendet werden, deren Kreisfläche die gleiche Größe wie die Fläche des zu vermessenden Kornes aufweist. Die Auswertung der Flächenanteile erfolgt auf einer Meßfläche, die von der Bildfläche an einer längeren und einer kürzeren Seite abgegrenzt ist, durch gerade parallele Streifen, die mindestens so breit sind, wie das die zugehörige Grenzlinie schneidende größte Korn. Es werden nur die Körner gewertet, die in ganzer Größe im Meßfeld liegen oder eine oder beide Grenzlinien schneiden. Die Bezugsfläche ist die Meßfläche. Es werden mittels eines handelsüblichen Digitalisierungs-Gefügeanalysators, wie z.B. MOP-Videoplan (Fa. Zeiss), die Cluster von größeren Partikeln, bzw. die Bezugsfläche umfahren. Beide Werte werden in Beziehung gesetzt und ergeben einen Prozentsatz für den Flächenanteil der größeren Körner.

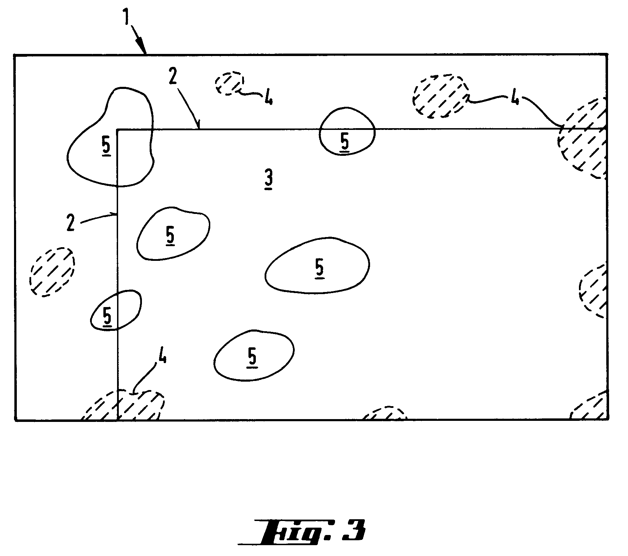

Figur 3 erläutert das Auswertungsschema. Aus dem Foto 1 wird das kleinere Meßfeld 3 durch die Begrenzungslinien 2 abgetrennt. Gestrichelt dargestellte Körner 4 werden nicht gezählt. Gewertet werden die Körner 5 im Meßfeld 2. Für eine repräsentative Aussage ist es sinnvoll mehrere, z.B. 10 Gefügeaufnahmen zu untersuchen.

Bei der Untersuchung von Schichten aus Nickel/Kobalt und/oder Eisen die bereits mit einer Edelmetallschicht überzogen werden, geht man analog vor. Vorher muß jedoch das Edelmetall entfernt werden. Gold läßt sich beispielsweise mit einer handelsüblichen (Cyanid-Ionen enthaltenden) Stripper-Lösung ablösen. Danach wird die Probe gewaschen, getrocknet und für die REM-Untersuchung präpariert.

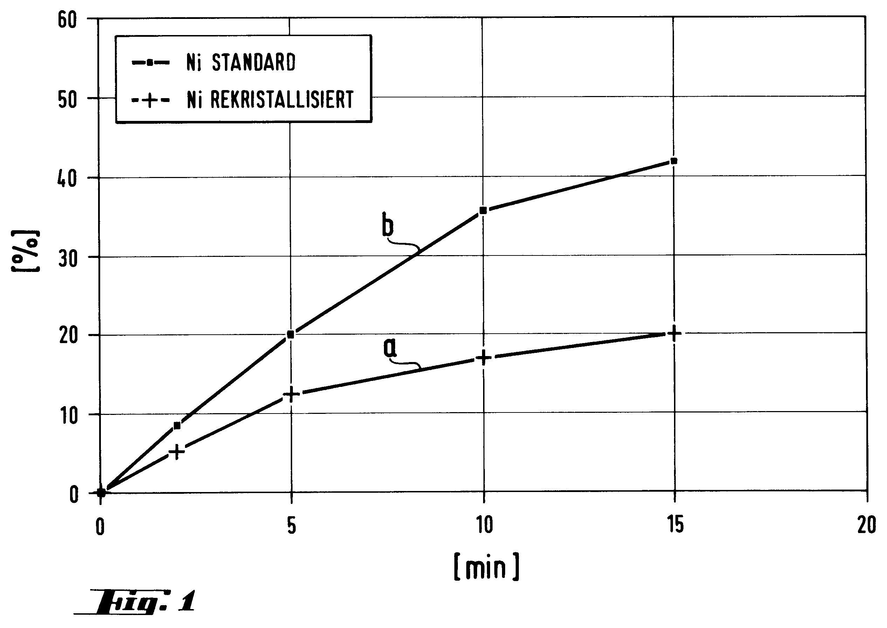

In Figur 1 wird die Menge von Nickel, das durch eine 2,3 $\mu$m starke Goldschicht hindurchdiffundiert ist, gegen die Diffusionsdauer aufgetragen. Auf der Abszisse ist die Dauer der Wärmebehandlung bei 480°C (in min), auf der Ordinate das Verhältnis Nickel-peak/Gold-peak (bestimmt nach der EDX-Methode bei 15 kV und einer Vergrößerung um das 1800fache) in % angegeben. Dabei war Probe (a) nach dem erfindungsgemäßen Verfahren erhalten worden, Probe (b) bestand aus einer vergoldeten, nicht thermisch behandelten Nickelschicht. Die Menge an diffundiertem Nickel ist bei Probe (a) deutlich geringer.

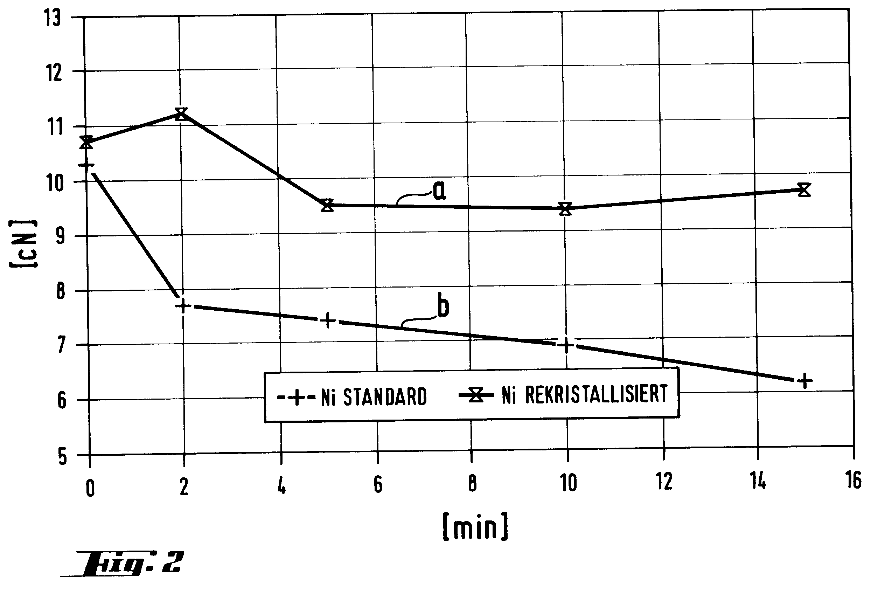

In Figur 2 wird die Abreißkraft von Aluminiumdrähten verglichen, die auf vergoldeten Nickelflächen gebondet wurden. Bei Probe (a) bestand diese Fläche aus einer vergoldeten Nickelschicht, die nach dem erfindungsgemäßen Verfahren hergestellt wurde, bei Probe (b) aus einer thermisch nicht behandelten Nickelschicht, mit der gleichen Goldbeschichtung. Auf der Abszisse ist die Zeitdauer der Wärmebehandlung bei einer Temperatur von 480°C (in min) vor dem Bonden, auf der Ordinate die erforderliche Abreißkraft des Drahtes (in cN) aufgetragen. Die erfindungsgemäß rekristallisierten Teile (a) zeigen deutlich höhere Abreißkräfte als die nicht wärmebehandelten Proben (b).

Die Erfindung wird durch die nachfolgenden Ausführungsbeispiele näher erläutert, ohne auf die konkret dargestellen Ausführungsformen beschränkt zu sein.

## Beispiel 1

Aus metallisierter Keramik hergestellte Gehäuse für elektronische Schaltungen (Pin Grid Arrays) wurden in einem handelsüblichen Sulfamatnickelbad kathodisch mit einer Nickelschicht einer Dicke von 2 $\mu$m überzogen. Nach sorgfältiger Spülung mit Wasser wurden die Bauteile in einer 5 % Wasserstoff enthaltenden Stickstoffatmosphäre über eine Zeitdauer von 7 h bei einer Temperatur von 700°C gehalten. Nach dem Abkühlen war die Vergrößerung der Kristallite von unter 0,1 $\mu$m auf ca. 5 $\mu$m unter dem Mikroskop gut erkennbar. Die Bauteile wurden kathodisch mit einer Schicht von 1,5 $\mu$m Feingold überzogen. Sie können danach für 10 bis 15 Minuten an Luft auf 500°C erhitzt werden, ohne daß eine sichtbare Dunkelfärbung eintritt. Die Bondfestigkeit ist sehr gut.

## Beispiel 2 (Vergleichsbeispiel)

Aus metallisierter Keramik bestehende Gehäuse für elektronische Schaltungen wurden genauso hergestellt wie in Beispiel 1 beschrieben, es wurde jedoch keine Nachbehandlung bei 700°C in H$_2$/N$_2$-Atmosphäre durchgeführt. Die Proben sollten dann ebenfalls bei einer Temperatur von 500°C in sauerstoffhaltiger Umgebung getestet werden, jedoch begann beim Aufheizen bereits eine deutlich sichtbare Verfärbung nach etwa 2 bis 3 Minuten.

## Beispiel 3

Wie in Beispiel 1 wurde auf ein keramisches Bauteil (Pin Grid Array) eine ca. 2 $\mu$m starke Nickelschicht außenstromlos aufgebracht. Das verwendete Bad enthielt Natriumhypophosphit und die entstehende Nickelschicht 10 Gew.% Phosphor. Die Rekristallisation erfolgte über eine Zeitdauer von 30 Minuten bei 770°C. Anschließend wurden die Bauteile wie in Beispiel 1 vergoldet. Die so hergestellten Bauteile können an der Luft für 15 bis 30 Minuten auf eine Temperatur von 500°C aufgeheizt werden, ohne daß eine erkennbare Verfärbung der Goldschicht oder eine Beeinträchtigung der Bondbarkeit eintritt.

## Beispiel 4

Ein keramische Bauteil (Pin Grid Array) wurde in einem handelsüblichen, galvanisch arbeitendem NiP-Legierungsbad so vernickelt, daß der Phosphorgehalt der Nickelschicht 13,5 Gew.-% betrug und die Schicht eine Schichtdicke von 2 $\mu$m aufwies. Das Bauteil wurde dann über eine Zeitspanne von 30 Minuten bei einer Temperatur von 770°C gehalten. Nach dem kathodischen Vergolden, bei dem eine 1,5 $\mu$m dicke Schicht aus Feingold aufgetragen wurde, wurde das Bauteil 60 Minuten an Luft auf 500°C aufgeheizt. Eine merkliche Dunkelfärbung der Goldschicht trat nicht ein, ihre Bondbarkeit ist nicht beeinträchtigt

## Beispiel 5

Ein Gehäuse bestehend aus der Legierung Fe29Ni34Co17 mit einer Wandstärke von 0,5 mm und 28 Drähten aus der gleichen Legierung, die elektrisch isolierend mittels Glaslot durch das Gehäuse hindurchgeführt sind, wurde bei 700°C sieben (7) Stunden lang rekristallisiert. Nach dem autokatalytischen Vergolden (Aktivierung mit Palladium) lag eine 1 $\mu$m dicke Schicht aus Feingold vor. Beim Erwärmen des Gehäses an Luft auf 480°C wird keine Verfärbung der Goldschicht beobachtet.

## Patentansprüche

1. Verfahren zur Herstellung einer Edelmetallbeschichtung auf einer Metallschicht, die mindestens zu 70 Gew.-% aus Eisen, Kobalt und/oder Nickel besteht und deren Kristallite eine mittlere Korngröße von maximal 0,5 $\mu$m aufweisen, bei dem man die Metallschicht mit einer 0,1 bis 10 $\mu$m dicken Edelmetallschicht außenstromlos oder galvanisch überzieht, dadurch gekennzeichnet, daß man die Metallschicht vor dem Beschichten mit dem Edelmetall in einer nicht oxidierenden Atmosphäre solange auf eine Temperatur im Bereich von 500°C bis 1300°C erhitzt, bis mindestens 30 Flächen-% der Metalloberfläche Metallkristallite tragen, die eine Korngröße von mindestens 2 $\mu$m aufweisen, oder bis mindestens 50 Flächen-% der Metalloberfläche Metallkristallite tragen, die eine Korngröße von mindestens 1 $\mu$m aufweisen, man die Metallschicht abkühlt und dann mit der Beschichtung aus Edelmetall überzieht.

2. Verfahren nach Anspruch 1, dadurch gekennzeichnet, daß man die Metallschicht auf eine Temperatur unterhalb des Schmelzpunktes der Metallschicht erhitzt.

3. Verfahren nach Anspruch 1 oder 2, dadurch gekennzeichnet, daß man die Metallschicht in einer $H_2/N_2$-Atmosphäre oder im Vakuum erhitzt.

4. Verfahren nach einem der Ansprüche 1 bis 3, dadurch gekennzeichnet, daß man als Edelmetall Gold einsetzt.

5. Bauteil mit einer edelmetallbeschichteten Metallschicht, bei dem das Metall wenigstens 70 Gew.-% Eisen, Kobalt und/oder Nickel enthält und das Edelmetall eine Schichtdicke von 0,1 bis 10 $\mu$m aufweist, dadurch gekennzeichnet, daß an der von dem Edelmetall überzogenen Oberfläche der Metallschicht Metallkristallite vorhanden sind, wobei mindestens 30 % der Metallkristallite an der Oberfläche eine Korngröße von mindestens 2 $\mu$m oder mindestens 50 % eine Korngröße von mindestens 1 $\mu$m aufweisen.

6. Bauteil gemäß Anspruch 5, dadurch gekennzeichnet, daß die Metallschicht in Form eines Blechs mit einer Dicke im Bereich von 0,1 bis 10 mm vorliegt.

7. Bauteil gemäß Anspruch 5 oder 6, dadurch gekennzeichnet, daß die Metallschicht eine Schichtdicke von 0,5 bis 50 $\mu$m aufweist und auf einem Keramikkörper angeordnet ist.

8. Bauteil nach einem der Ansprüche 5 bis 7, dadurch gekennzeichnet, daß die Metallschicht zusätzlich 1 bis 20 Gew.-% Phosphor oder 0,1 bis 5 Gew.-% Bor und/oder bis zu 20 Gew.-% Chrom, Mangan, Molybdän und/oder Wolfram enthält.

9. Bauteil nach einem der Ansprüche 5 bis 8, dadurch gekennzeichnet, daß die Kristallite der Metallschicht eine Vorzugsrichtung aufweisen.

10. Verwendung eines Bauteils gemäß einem der Ansprüche 5 bis 9, hergestellt nach einem Verfahren gemäß einem der Ansprüche 1 bis 4 zur Aufnahme integrierter Schaltkreise, insbesondere bei Temperaturen von 400 bis 500°C zur vorzugsweisen Befestigung mit einem glashaltigen Lot.

**Fig. 1**

EP 0 496 372 A2

Fig. 2

*Fig. 3*